# EUROPEAN PATENT APPLICATION

(11) **EP 1 848 034 A2**
(43) Date of publication of application: **24.10.2007**
(21) Application number: 07106386.1
(22) Date of filing: 18.04.2007
(51) Int. Cl.: H01L 23/14, H01L 23/04

(54) **Electronic component device**

(30) Priority: 18.04.2006 JP 2006114309
(71) Applicant: SHINKO ELECTRIC INDUSTRIES CO., LTD., Nagano-shi, Nagano 381-2287 (JP)
(72) Inventor: Koizumi, Naoyuki Shinko Electric Industries Co., Ltd., Nagano 381-2287 (JP); Hiagashi, Mitsutoshi Shinko Electric Industries Co., Ltd., Nagano 381-2287 (JP)
(74) Representative: Fenlon, Christine Lesley

(57) **Abstract**

An electronic component device includes a package main body (30) constructed by a lower package portion (10) and an upper package portion (20) and having a housing portion (S) in an inside, and an electronic component (40) mounted in a state that the electronic component (40) is hermetically sealed in the housing portion (S) of the package main body (30), wherein at least the lower package portion (10) out of the lower package portion (10) and the upper package portion (20) is formed of silicon, in the case that an optical device as the electronic component (40) is mounted, a transparent glass (34) (light transmission window glass) is provided to an opening portion (20x) formed in the upper package portion (20).

## Description

### BACKGROUND OF THE INVENTION

### 1. Field of the Invention

The present invention relates to an electronic component device and, more particularly, an electronic component device having such a structure that an electronic component is mounted in a hermetic sealed condition in a package.

### 2. Description of the Related Art

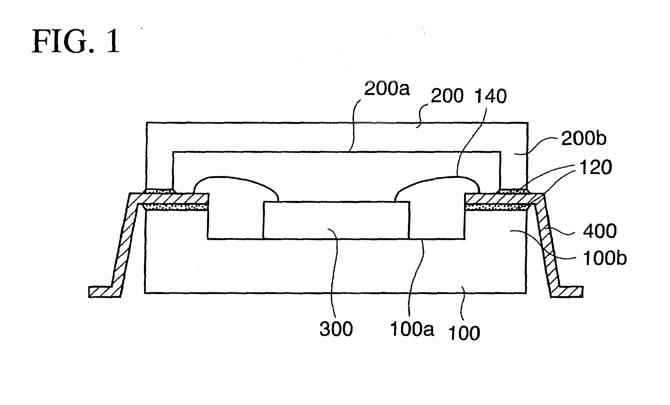

In a previously-proposed electronic component device of CERDIP (Ceramic Dual Inline Package) type, the electronic component is mounted in a hermetic sealed condition in the package. As shown in FIG.1, in such electronic component device in the prior art, an electronic component 300 is mounted on a bottom portion of a recess portion 100a of a lower ceramic base 100, in which the recess portion 100a is formed in a center portion and a projection portion 100b is provided to the peripheral side. A lead 400 extending outward is adhered to the projection portion 100b of the lower ceramic base 100 with a low-melting glass 120, and the electronic component 300 is connected to the lead 400 by wires 140.

Also, a projection portion 200b of an upper ceramic base 200, in which a recess portion 200a is formed in a center portion and the projection portion 200b is provided to the peripheral side, is adhered to the projection portion 100b of the lower ceramic base 100 with the low-melting glass 120. In this manner, the electronic component 300 is mounted to be housed in a hermetic sealed condition in a space between the lower ceramic base 100 and the upper ceramic base 200.

As the related art, in Patent Literature 1 (Patent Application Publication (KOKAI) 2005-235864), the optical semiconductor device constructed such that the semiconductor photodetector is hermetically sealed by mounting the semiconductor photodetector on a vessel (ceramic) consisting of the bottom portion and the wall portion and then arranging the cap member consisting of the window material (quartz glass) and the window frame on the vessel, is set forth.

Also, in Patent Literature 2 (Patent Application Publication (KOKAI) Hei 6-291213), it is set forth that, in order to constitute the device mounting surface and the cap joining surface as parallel surfaces of good precision, upon forming the package by joining the ceramic frame body to the ceramic base, end surfaces of the projection portions provided to the ceramic frame body are joined to be put to the ceramic base.

However, when the hermetic sealed package is formed of the ceramic like the prior art, such package is obtained by sintering the ceramic powder molding body molded by using the die. Therefore, deformation or warp easily occurs in the sintering process, and it is difficult to form the hermetic sealed package with high dimensional precision. As a result, there exists such a problem that, when particularly the package of which high dimensional precision is required should be manufactured, manufacturing yield is low to bring about a high cost.

### SUMMARY OF THE INVENTION

It is desirable to provide an electronic component device having a structure that a package can be formed with high dimensional precision and at a low cost, in the electronic component device in which an electronic component is mounted in a hermetic sealed condition.

An electronic component device embodying the present invention includes a package main body constructed by a lower package portion and an upper package portion, and having a housing portion in an inside; and an electronic component mounted in a state that the electronic component is hermetically sealed in the housing portion of the package main body, wherein at least the lower package portion out of the lower package portion and the upper package portion is formed of silicon.

In an electronic component device embodying the present invention, the package main body is constructed by adhering the upper package portion onto the lower package portion such that the housing portion is provided in the inside, and the electronic component is mounted in the housing portion in a hermetic sealed condition. Also, at least the lower package portion out of the upper package portion and the lower package portion is formed of silicon. Since the silicon can be processed by RIE, wet etching, or the like with high precision, dimensional precision can be improved remarkably rather than the case where the ceramic package obtained by sintering the ceramic powder molding is used. Also, since plural product parts can be obtained by forming a plurality of package portions on the silicon wafer and cutting the wafer into individual pieces, a lower cost can be attained.

In a package main body of an electronic component device embodying the present invention, either the light transmission window portion (the transparent glass) may be provided in the center portion of the upper package portion, or the light transmission window portion may not be provided.

When the light transmission window portion is provided, the upper package portion is formed of ceramic having an opening portion in a center portion, and the light transmission window portion is adhered to the side surface portion of the opening portion in an inclined state to a light receiving surface of the electronic component. Otherwise, a horizontal surface of the light transmission window portion whose a pair of opposing surfaces in a light transmitting direction are constructed by a combination of a horizontal surface and a inclined surface may be is adhered to a neighboring portion of the opening portion of the upper package portion.

Accordingly, the light transmission window portion is arranged to have an inclined surface that is inclined from the light receiving surface of the electronic component.

In one preferred embodiment of the present invention, through electrodes are provided in through holes formed in the outside portion of an area of the lower package portion on which the electronic component is mounted, and the electronic component is connected to the through electrodes via wires. In the case of this mode, since the lower package portion (silicon) can be formed with good dimensional precision, a narrower pitch of the through holes (through electrodes) can be made easy and also this package can deal easily with the package for the high performance electronic component.

Also, in the above embodiment of the present invention, leads extended from an inner portion of the package main body to an outer portion may be inserted between the lower package portion and the upper package portion, and the electronic component may be connected to the leads of the inner portion via wires.

Also, in the above embodiment of the present invention, opening portions may be provided to an outside portion of an area of the lower package portion on which the electronic component is mounted, the leads whose connection portions are exposed to the opening portions may be provided on an outer surface side of the lower package portion to extend sideward, and the electronic component may be connected to the connection portions of the leads via wires.

Also, in the above embodiment of the present invention, the lower package portion and the upper package portion may be adhered with a resin, and a sealing member for sealing the resin may be provided on a side portion of the package main body.

Further, in the embodiment of the above present invention, the through electrodes may be formed as projected through electrodes projected upward from an inner surface of the lower package portion, and the electronic component may be electrically connected to the projected through electrodes by adhering the electronic component onto the projected through electrodes.

As explained above, in an electronic component device embodying the present invention, a part or all of hermetic sealed package is formed of silicon. Therefore, the package main body of high dimensional precision can be obtained, and the high performance electronic component can be mounted easily.

### BRIEF DESCRIPTION OF THE DRAWINGS

FIG.1 is a sectional view showing a previously-proposed hermetic sealed electronic component device;
FIG.2 is a sectional view showing an electronic component device of a first embodiment of the present invention;
FIG.3 is a sectional view showing an electronic component device of a variation of the first embodiment of the present invention;
FIG.4 is a sectional view showing an electronic component device of a second embodiment of the present invention;
FIG.5 is a sectional view showing an electronic component device of a third embodiment of the present invention;
FIG.6 is a sectional view showing an electronic component device of a fourth embodiment of the present invention;
FIG.7 is a sectional view showing an electronic component device of a fifth embodiment of the present invention;
FIG.8 is a sectional view showing an electronic component device of a variation of the fifth embodiment of the present invention;
FIG.9 is a sectional view showing an electronic component device of a sixth embodiment of the present invention;
FIG.10 is a sectional view showing an electronic component device of a variation of the sixth embodiment of the present invention;
FIG.11 is a sectional view showing an electronic component device of a seventh embodiment of the present invention; and
FIG.12 is a sectional view showing an electronic component device of an eighth embodiment of the present invention.

### DETAILED DESCRIPTION OF THE PREFERRED EMBODIMENTS

Embodiments of the present invention will be explained with reference to the accompanying drawings hereinafter.

### (First Embodiment)

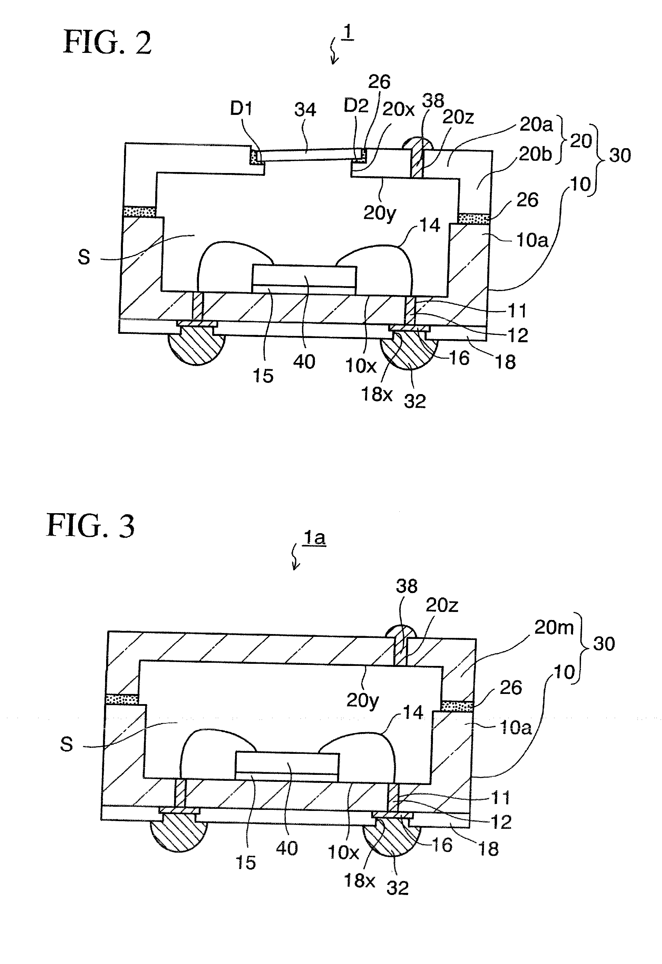

FIG.2 is a sectional view showing an electronic component device of a first embodiment of the present invention. As shown in FIG.2, a package main body 30 of an electronic component device 1 of the first embodiment is constructed by arranging a ring-like upper ceramic package portion 20 on a lower silicon package portion 10. In the lower silicon package portion 10, a projection portion 10a is provided to the peripheral portion by forming a recess portion 10x in a major center portion. Also, an electronic component 40 is adhered to a bottom surface of the recess portion 10x of the lower silicon package portion 10 with a die attachment member 15.

As the electronic component 40, the component of a type that it is mounted in a hermetic sealed condition in the package such as optical switching device, memory device such as EEPROM, or the like, MEMS (Micro Electro Mechanical Systems) device, imaging device (CMOS sensor or CCD), or the like is used.

Also, through holes 11 passing through from an inner surface to an outer surface are provided in the outside portion of an area of the lower silicon package portion 10 on which the electronic component 40 is mounted. Through electrodes 12 are formed to be filled in the through holes 11. Also, the electronic component 40 is electrically connected to top portions of the through electrodes 12 via wires 14.

Connection pads 16 connected to the through electrodes 12 are provided to an outer surface (lower surface) of the lower silicon package portion 10. A protection layer 18 in which opening portions 18x are provided on the connection pads 16 is formed on the lower surface of the lower silicon package portion 10. External connection terminals 32 made of solders or the like and connected to the connection pads 16 are provided to the outer surface side of the lower silicon package portion 10.

The upper ceramic package portion 20 is constructed by an upper frame portion 20a in a center portion of which an opening portion 20x is provided, and an upright frame portion 20b provided to be connected to a peripheral lower portion of the upper frame portion 20a. Thereby, the upper ceramic package portion 20 has a recess portion 20y in the inside. Stepped portions D1, D2 a height of which is different mutually are provided to side surface portions of the opening portion 20x of the upper ceramic package portion 20. Both end portions of a transparent glass 34 (light transmission window portion) are adhered to the stepped portions D1, D2 with a low-melting glass 26. Accordingly, the transparent glass 34 is fitted to the opening portion 20x in a state that the transparent glass 34 is inclined at an angle of about 3 ° to a light receiving surface (mounting surface) of the electronic component 40. Here, the upper package portion made of metal, resin, or the like may be employed in place of the upper ceramic package portion 20.

Also, the upright frame portion 20b of the upper ceramic package portion 20 is adhered to the projection portion 10a of the lower silicon package portion 10 with the low-melting glass 26 such that the recess portion 20y of the upper ceramic package portion 20 opposes to the recess portion 10x of the lower silicon package portion 10. In this manner, the electronic component 40 is mounted in the package main body 30 in a state that the electronic component 40 is hermetically sealed in a housing portion S between the lower silicon package portion 10 and the upper ceramic package portion 20.

In an example in FIG.2, the housing portion S of the package main body 30 is set to a vacuum condition, and an exhaust port 20z used to produce a vacuum in the housing portion S is provided to the upper frame portion 20a of the upper ceramic package portion 20. After a pressure of the housing portion S is reduced through the exhaust port 20z to create a vacuum therein, the exhaust port 20z is sealed with a sealing portion 38 made of solder, or the like. In this case, when an inside of the housing portion S is set to an atmospheric pressure, provision of the exhaust port 20z is not needed.

The lower silicon package portion 10 of the electronic component device 1 of the present embodiment is obtained by processing the silicon wafer by RIE, wet etching, or the like with high precision. Therefore, dimensional precision can be improved remarkably rather than the case where the ceramic that causes a warp or a deformation in forming the package is used. As a result, the package of the present embodiment can deal easily with the case where the through holes 11 should be formed in the lower silicon package portion 10 with a narrower pitch to meet the demand for a miniaturization of the electronic component device, and the high performance electronic component 40 can be mounted in the package.

Also, plural product parts can be obtained by forming a plurality of lower silicon package portions 10 on the silicon wafer and cutting the wafer into individual pieces. Also, the silicon wafer may be cut after the electronic component is respectively mounted in individual package areas of the silicon wafer in which a plurality of lower silicon package portions 10 are formed. In this manner, since a plurality of lower silicon package portions 10 can be obtained from the silicon wafer, a lower cost can be attained.

In addition, since the electronic component 40 (semiconductor (silicon) device) is mounted on the lower silicon package portion 10, both coefficients of thermal expansion can be made equal to each other. Therefore, generation of peeling, crack, or the like of the electronic component 40 by thermal stress can be prevented, and reliability of the electronic component device can be improved.

In the example in FIG.2, the optical switching element of the projector is employed as the electronic component 40. In this case, light from a light source is transmitted through the transparent glass 34 and then is reflected by the optical switching element, and the reflected light is transmitted through the transparent glass 34 and then is projected onto an external screen, so that the image is formed on the screen. In the present embodiment, since the transparent glass 34 is arranged at a desired inclination angle (e.g., about 3 °), the reflected light from a surface of the transparent glass 34 is reflected to an area except the projected image. As a result, a contrast ratio of the projected image can be enhanced, and improvement of the display characteristic can be achieved.

An electronic component device 1a of a variation of the first embodiment of the present invention is shown in FIG.3. As shown in FIG.3, in the electronic component device 1a of the variation of the first embodiment, provision of the light transmission window portion (transparent glass 34) is not needed. Instead of the above upper ceramic package portion 20 in FIG.2, an upper package portion 20m in which the opening portion 20x is not formed is arranged on the lower silicon package portion 10. When the opening portion 20x is not formed, the upper package portion 20m may be formed of silicon. Otherwise, the upper package portion 20m may be formed of ceramic, or the like.

When the upper package portion 20m is formed of silicon, the overall package main body 30 is formed of silicon. Thus, the package main body 30 of higher dimensional precision can be obtained. In the electronic component device 1a of the variation of the first embodiment, since the light transmission window portion (transparent glass 34) is not provided, electronic components other than the optical device can be mounted.

### (Second Embodiment)

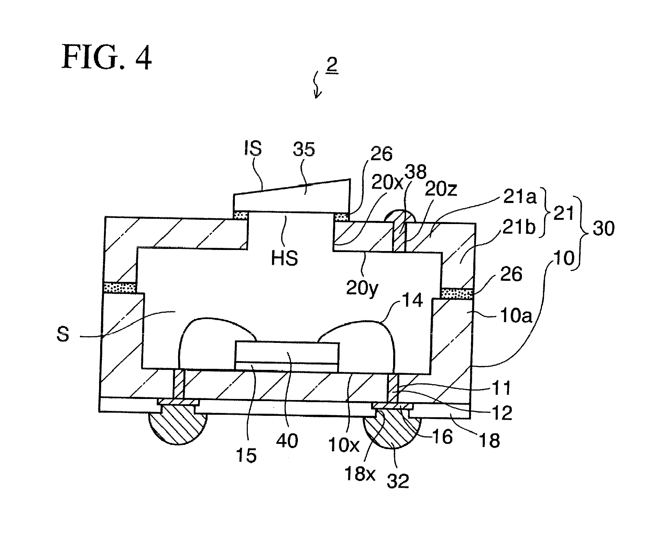

FIG.4 is a sectional view showing an electronic component device of a second embodiment of the present invention. As shown in FIG.4, in an electronic component device 2 of the second embodiment, an upper silicon package portion 21 is employed instead of the above upper ceramic package portion 20 of the first embodiment (FIG.2). The upper silicon package portion 21 is constructed by an upper frame portion 21a to a center portion of which the opening portion 20x is provided, and an upright frame portion 21b. Also, a transparent glass 35 is adhered to the neighboring portion of the opening portion 20x on the outer surface side of the upper silicon package portion 21 with the low-melting glass 26.

An upper surface of the transparent glass 35 constitutes an inclined surface IS inclined at a desired angle, and a lower surface thereof constitutes a horizontal surface HS. The outer surface side of the upper silicon package portion 21 constitutes a horizontal surface that is parallel with the light receiving surface (mounting surface) of the electronic component device. By adhering the horizontal surface HS of the transparent glass 35 onto the outer surface of the upper silicon package portion 21, the transparent glass 35 is arranged to have the inclined surface IS that is inclined at a desired angle to the light receiving surface of the electronic component 40.

In this case, by adhering the horizontal surface HS of the transparent glass 35 onto the inner surface side of the upper silicon package portion 21, the inclined surface IS of the transparent glass 35 may be arranged on the housing portion S side of the package main body 30.

In the second embodiment, since the package main body 30 is formed of silicon as a whole, the package main body 30 of higher dimensional precision can be obtained.

Also, when the overall package main body 30 is formed of silicon, individual electronic component devices can be obtained in such a manner that the electronic component is mounted in respective package areas of the silicon wafer on which a plurality of lower silicon package portions 10 are formed, then the silicon wafer on which a plurality of upper silicon package portions 21 are formed is adhered to the above silicon wafer with the low-melting glass 26, and then the silicon wafers are cut into individual pieces. Since such approach is employed, yield in assembling and a production efficiency can be improved, and a lower cost can be achieved.

In this case, when provision of the light transmission window portion (transparent glass 34) is not needed, the upper package portion formed of silicon (or ceramic, or the like) and not having the opening portion 20x may be employed, in place of the upper silicon package portion 21 in which the opening portion 20x is provided.

In the second embodiment (FIG.4), constituent elements except the upper silicon package portion 21 and the transparent glass 35 are identical to those in the first embodiment (FIG.2). Therefore, their explanation will be omitted herein by affixing the same reference symbols to them.

### (Third Embodiment)

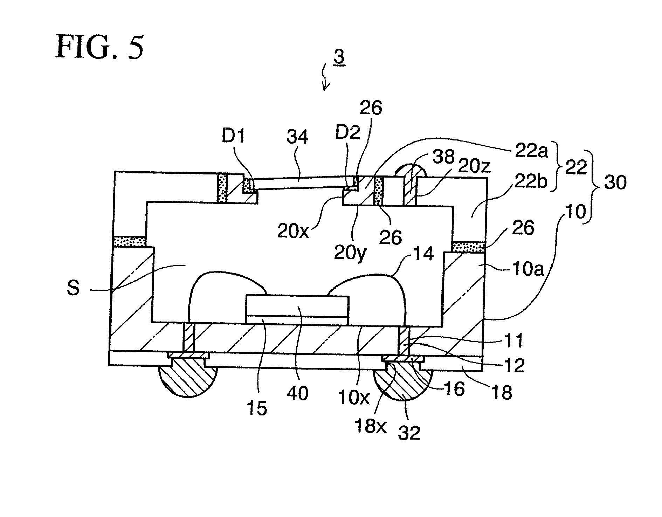

FIG.5 is a sectional view showing an electronic component device of a third embodiment of the present invention. In the foregoing electronic component device 1 of the first embodiment (FIG.2), such a situation may be supposed that, since the upper ceramic package portion 20 is made of ceramic, dimensional precision of the upper ceramic package portion 20 cannot be ensured with respect to the lower silicon package portion 10. Also, when the transparent glass 34 having no inclined surface is provided to the upper silicon package portion 21 to be inclined, the stepped portions having a different height respectively must be formed on the side surface portion of the opening portion of the silicon, like the case of ceramic. In the case of silicon, it is possible that the etching step grows complicated to bring about a cost increase.

For this reason, as shown in FIG.5, an upper package portion 22 of an electronic component device 3 is constructed such that the neighboring portion of the opening portion 20x is formed of a ring-like ceramic portion 22a and a ring-like silicon outer frame portion 22b is adhered to an outer peripheral side surface of the ceramic portion 22a with the low-melting glass 26. Therefore, the transparent glass 34 having no inclined surface can be arranged to be inclined on the stepped portions D1, D2 of the opening portion 20x of the ceramic portion 22a at a low cost. Also, since an outer frame portion of the upper package portion 22 is formed of silicon of high processing precision, dimensional precision of the outer frame portion can be improved rather than the case where the overall upper ceramic package portion 20 is made of ceramic.

In the third embodiment (FIG.5), constituent elements except the upper package portion 22 are identical to those in the first embodiment (FIG.2). Therefore, their explanation will be omitted herein by affixing the same reference symbols to them.

### (Fourth Embodiment)

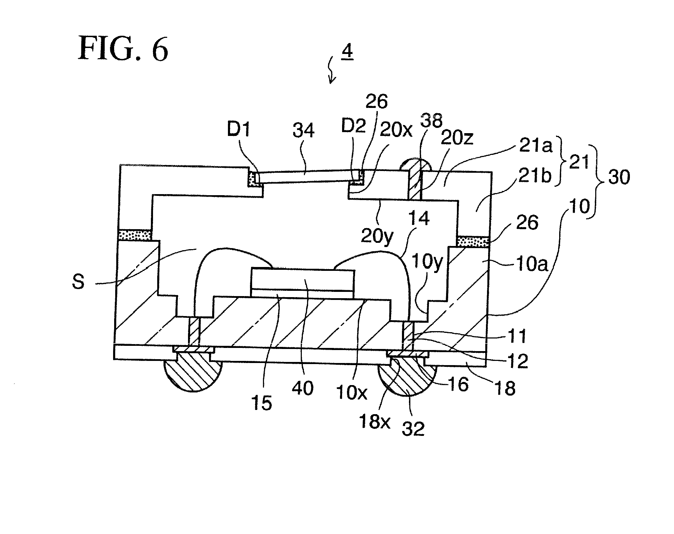

FIG.6 is a sectional view showing an electronic component device of a fourth embodiment of the present invention. As shown in FIG.6, in an electronic component device 4 of the fourth embodiment, a thickness of the bottom portion of the lower silicon package portion 10 is set thicker than that of the lower silicon package portion 10 in the first embodiment (FIG.2) to such an extent that enough rigidity can be ensured, and hollow portions 10y are formed locally in portions in which the through electrodes 12 are provided. The through hole 11 is provided in a center portion of the hollow portion 10y of the lower silicon package portion 10. The through electrodes 12 are filled in the through holes 11. The electronic component 40 is connected to the through electrodes 12 that are exposed from bottom portions of the hollow portions 10y of the lower silicon package portion 10, via the wires 14.

In the electronic component device 4 of the fourth embodiment, the lower silicon package portion 10 is set to a thickness enough to get sufficient rigidity, and also the hollow portions 10y are provided locally to the portions of the lower silicon package portion 10, in which the through electrodes 12 are provided, to reduce the thickness of those portions. Therefore, the through holes 11 and the through electrodes 12 can be formed easily.

Also, in the fourth embodiment (FIG.6), when there is no need to provide the light transmission window portion (transparent glass 34), the upper package portion formed of silicon (or ceramic, or the like) as a whole and having no opening portion may be employed.

In the fourth embodiment (FIG.6), constituent elements except the lower silicon package portion 10 are identical to those in the first embodiment (FIG.2). Therefore, their explanation will be omitted herein by affixing the same reference symbols to them.

### (Fifth Embodiment)

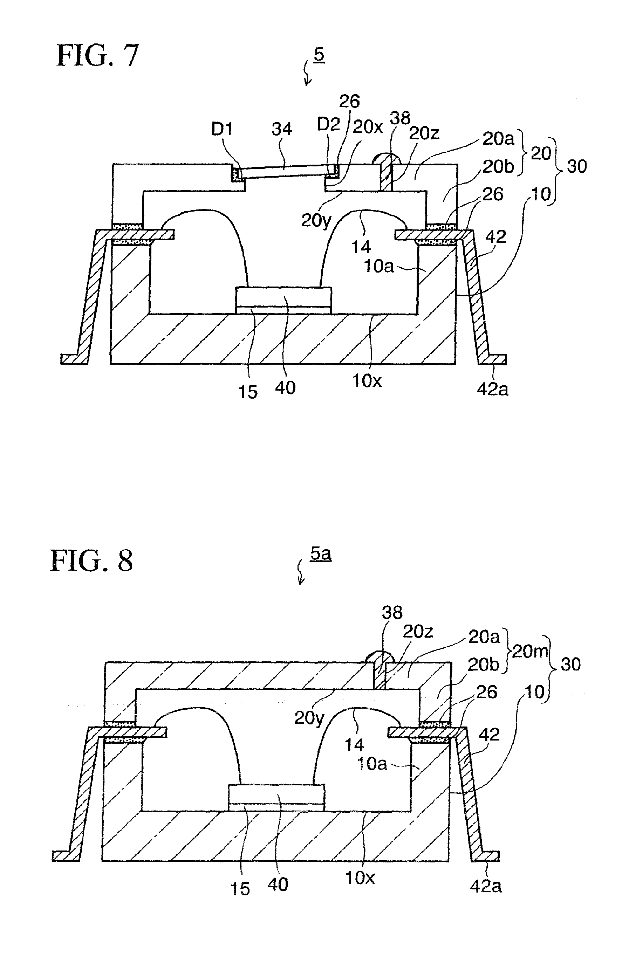

FIG.7 is a sectional view showing an electronic component device of a fifth embodiment of the present invention. As shown in FIG.7, in an electronic component device 5 of the fifth embodiment, no through electrode is provided in the lower silicon package portion 10, and a plurality of leads 42 are adhered with the low-melting glass 26 in a state that they are aligned between the projection portion 10a of the lower silicon package portion 10 and the upright frame portion 20b of the upper ceramic package portion 20. Each of the leads 42 extends from the inside of the package main body 30 to the outside. The lead 42 being extended outward is arranged to extent and to be bent downward, and an external connection portion 42a is provided in a position that corresponds to the bottom surface of the lower silicon package portion 10. Also, the electronic component 40 is connected electrically to the leads 42 of the inside of the package main body 30 via the wires 14.

In the fifth embodiment (FIG.7), other constituent elements are identical to those in the first embodiment (FIG.2) . Therefore, their explanation will be omitted herein by affixing the same reference symbols to them.

Like an electronic component device 5a of a variation of the fifth embodiment shown in FIG.8, when there is no need to provide the light transmission window portion (transparent glass 34), the upper package portion 20m formed of silicon (or ceramic, or the like) as a whole and having no opening portion 20x is employed.

In the fifth embodiment, like the first embodiment, a part or all of package main body 30 is formed of silicon. Therefore, the package main body 30 of high dimensional precision can be obtained.

### (Sixth Embodiment)

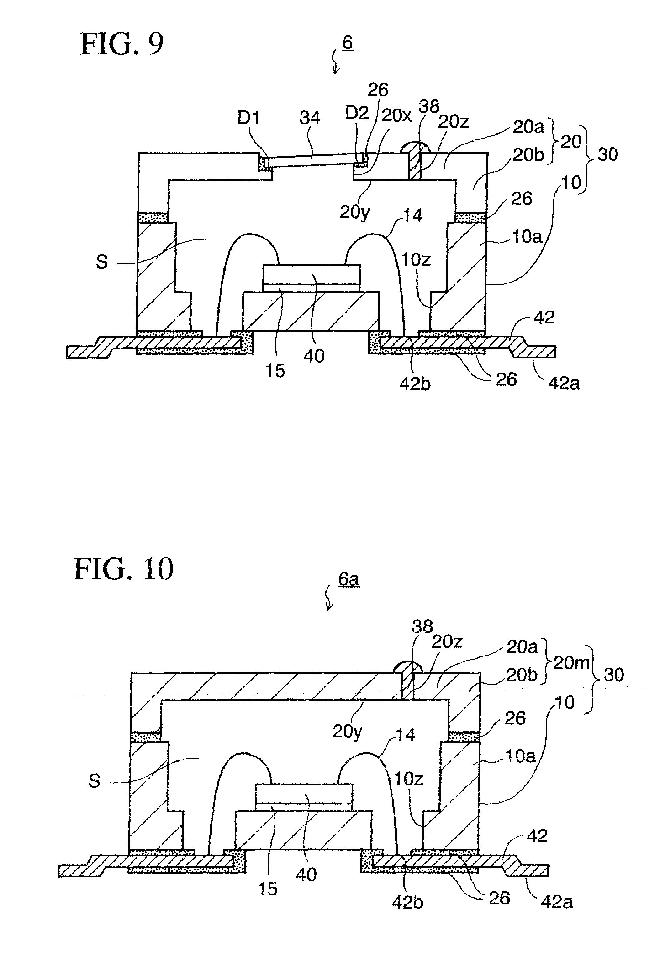

FIG.9 is a sectional view showing an electronic component device of a sixth embodiment of the present invention. As shown in FIG.9, in an electronic component device 6 of the sixth embodiment, opening portions 10z are provided on the outside portion of the area of the lower silicon package portion 10, the area in which the electronic component 40 is mounted, and the leads 42 are arranged below the opening portions 10z. The leads 42 are adhered to the outer surface (lower surface) of the lower silicon package portion 10 with the low-melting glass 26 such that internal connection portions 42b are exposed into the opening portions 10z, and the lower surface side of the lead 42 is covered with the low-melting glass 26. Also, the leads 42 extend sideward from the outer surface (lower surface) of the lower silicon package portion 10 to the outside, and the external connection portion 42a is provided to the top end portion of the lead 42.

Also, the electronic component 40 is connected electrically to the internal connection portions 42b of the leads 42 via the wires 14 that pass through the opening portions 10z of the lower silicon package portion 10.

In the sixth embodiment, the opening portions 10z are provided to the lower silicon package portion 10, and the leads 42 are adhered to the lower surface of the lower silicon package portion 10 with the low-melting glass 26 such that the internal connection portions 42b of the leads 42 are arranged in the opening portions 10z. Therefore, unlike the first embodiment, there is no need that the through electrodes 12 should be formed by applying the metal plating to the through holes 11 of the lower silicon package portion 10, and thus the manufacturing method can be simplified.

Also, in the above arrangement of the leads 42 of the electronic component device 2 of the fifth embodiment (FIG.7), the electronic component 40 must be connected to the leads 42 by the wires 14 before the upper ceramic package portion 20 is adhered onto the lower silicon package portion 10 with the low-melting glass 26. Therefore, the electronic component 40 must be connected to the leads 42 in a state that the leads 42 are being fixed by a special fixing jig. However, in the sixth embodiment, the electronic component 40 can be connected to the leads 42 via the wires 14 after the leads 42 are secured to the lower surface of the package main body 30 with the low-melting glass 26. Therefore, the electronic component 40 can be mounted by a simple method not to employ the fixing jig fixing the wires 14.

In the sixth embodiment (FIG.9), other constituent elements are identical to those in the first embodiment (FIG.2) . Therefore, their explanation will be omitted herein by affixing the same reference symbols to them.

Like an electronic component device 6a of a variation shown in FIG.10, when provision of the light transmission window portion (the transparent glass 34) is not needed, the upper package portion 20m formed of silicon (or ceramic, or the like) as a whole and having no opening portion 20x is employed.

### (Seventh Embodiment)

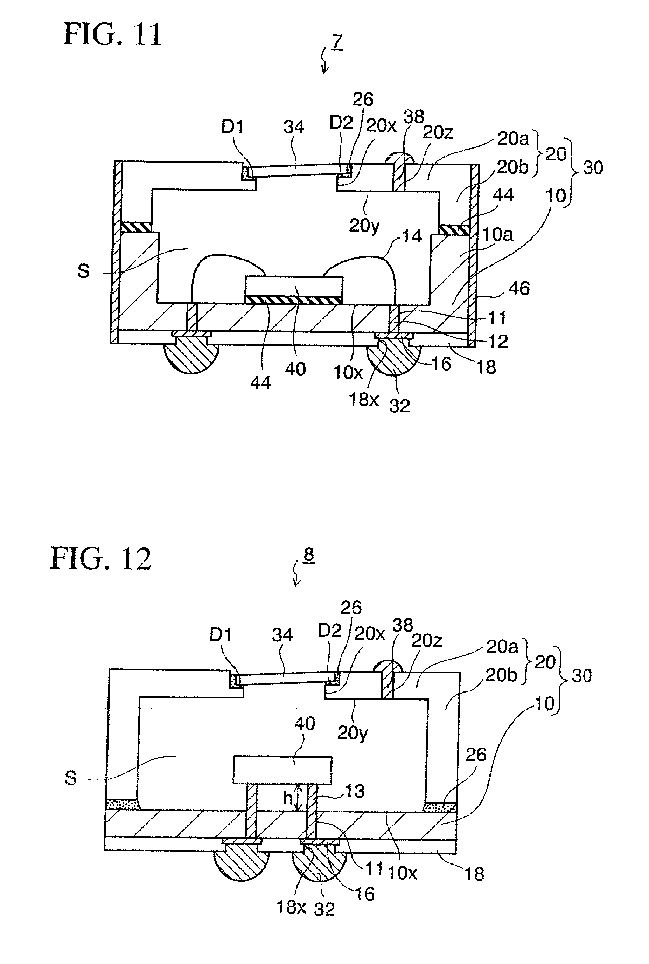

FIG.11 is a sectional view showing an electronic component device of a seventh embodiment of the present invention. As shown in FIG.11, in an electronic component device 7 of the seventh embodiment, the projection portion 10a of the lower silicon package portion 10 and the upright frame portion 20b of the upper ceramic package portion 20 are adhered together by an organic resin 44 such as an epoxy resin, or the like instead of the low-melting glass. Also, the electronic component 40 is adhered to the lower silicon package portion 10 by the organic resin 44 instead of the die attachment member.

The organic resin 44 can be adhered to be cured at a relatively low temperature such as about 200 °C. Therefore, the thermal damage to the electronic component 40 can be reduced rather than the case where the low-melting glass 26 whose curing temperature is 300 to 400 °C is used, and reliability of the electronic component device can be improved.

In this manner, in the seventh embodiment, sufficient reliability can be ensured even when the electronic component 40 having a low thermal resistance is employed, and various types of electronic components 40 can be mounted widely.

Here, the organic resin 44 has a merit of curing on the low temperature side (200 °C), nevertheless its hermetic sealing property for blocking moisture or a gas is not always satisfactory. For this reason, in the present embodiment, a sealing member 46 made of aluminum, or the like is provided on the side portion of the package main body 30 so as to get the satisfactory hermetic sealing property. Thus, the organic resin 44 is sealed with the sealing member 46.

The seventh embodiment can possess the similar advantages to those of the first embodiment. In addition to this, because a temperature in adhering the lower silicon package portion 10 and the upper ceramic package portion 20 can be set low and the satisfactory hermetic sealing property can be obtained, reliability of the electronic component device can be improved.

In the seventh embodiment (FIG.11), other constituent elements are identical to those in the first embodiment (FIG.2) . Therefore, their explanation will be omitted herein by affixing the same reference symbols to them.

### (Eighth Embodiment)

FIG.12 is a sectional view showing an electronic component device of an eighth embodiment of the present invention. As shown in FIG.12, in an electronic component device 8 of the eighth embodiment, the lower silicon package portion 10 is shaped into a flat plate not to have the recess portion. Also, the upright frame portion 20b of the upper ceramic package portion 20 similar to that on the first embodiment is adhered to the peripheral portion of the lower silicon package portion 10 with the low-melting glass 26. The through holes 11 are provided in the mounting area of the lower silicon package portion 10, and a projected through electrodes 13 are formed to be filled in the through holes 11. The projected through electrodes 13 are arranged to stand upright with a height h from the inner surface of the lower silicon package portion 10. Also, the electronic component 40 is mounted to be arranged on the projected through electrodes 13. Then, the electronic component 40 is connected electrically to the projected through electrodes 13 by adhering the connection portions provided to its device surface side to top end portions of the projected through electrodes 13 via a solder, or the like.

Such electronic component 40 is LED (Light Emitting Diode), for example, and the lower surface side of the electronic component 40 constitutes a device surface (light emitting surface), and light is emitted toward the lower silicon package portion 10 side. A mirror, or the like is arranged on the lower silicon package portion 10. The emission light from the electronic component 40 is reflected by the mirror, then is passed through the transparent glass 34, and then is emitted to the outside.

The eighth embodiment can possess the similar advantages to those of the first embodiment. In addition to this, the package of a type that the electronic component device is mounted in the housing portion in a state such the device is separated upward from the lower package portion and is hermetically sealed, can be formed with high dimensional precision.

## Claims

1. An electronic component device, comprising:
a package main body (30) constructed by a lower package portion (10) and an upper package portion (20), and having a housing portion (S) in an inside; and
an electronic component (40) mounted in a state that the electronic component (40) is hermetically sealed in the housing portion (S) of the package main body (30);
wherein at least the lower package portion (10) out of the lower package portion (10) and the upper package portion (20) is formed of silicon.

2. An electronic component device according to claim 1, wherein both of the lower package portion (10) and the upper package portion (20) are formed of silicon.

3. An electronic component device according to claim 1, wherein the upper package portion (20) is formed of ceramic having an opening portion (20x) in a center portion, and a light transmission window portion (34) is adhered to a side surface portion of the opening portion (20x) with an inclined state to a light receiving surface of the electronic component (40).

4. An electronic component device according to claim 1, wherein the upper package portion (20) is formed of silicon having an opening portion (20x) in a center portion, and a horizontal surface of a light transmission window portion (35) whose a pair of opposing surfaces in a light transmitting direction are constructed by a combination of the horizontal surface and a inclined surface, is adhered to a neighboring portion of the opening portion (20x) of the upper package portion (20),
thereby, the light transmission window portion (35) is arranged to have an inclined surface that is inclined from a light receiving surface of the electronic component (40).

5. An electronic component device according to any preceding claim, wherein a through electrode (12) passing through from an inner surface to an outer surface is provided to an outside portion of an area of the lower package portion (10), the area on which the electronic component (40) is mounted, and the electronic component (40) is connected to the through electrode (12) via a wire (14).

6. An electronic component device according to any preceding claim, wherein an external connection terminal (32) connected to the through electrode (12) is provided on an outer surface side of the lower package portion (10).

7. An electronic component device according to any one of claims 1 to 5, wherein a lead (42) extended from an inner portion of the package main body (30) to an outer portion thereof is inserted between the lower package portion (10) and the upper package portion (20), and the electronic component (40) is connected to the lead (42) of the inner portion via a wire (14).

8. An electronic component device according to any one of claims 1 to 5, wherein an opening portion (10z) is provided to an outside portion of an area of the lower silicon package portion (10), the area on which the electronic component (40) is mounted, a lead (42) whose connection portion (42b) is exposed in the opening portion (10z) is provided on an outer surface side of the lower package portion (10) to extend sideward, and the electronic component (40) is connected to the connection portion (42b) of the lead (42) via a wire (14).

9. An electronic component device according to any preceding claim, wherein the lower package portion (10) and the upper package portion (20) are adhered with a resin (44), and a sealing member (46) for sealing the resin (44) is provided on a side portion of the package main body (30).

10. An electronic component device according to claim 5, wherein the through electrode (12) is formed as a projected through electrode (13) projected upward from an inner surface of the lower package portion (10), and the electronic component (40) is adhered onto the projected through electrode (13), thereby the electronic component (40) is electrically connected to the projected through electrode (13).
